# EUROPEAN PATENT APPLICATION

(11) **EP 0 696 844 A1**
(43) Date of publication of application: **14.02.1996**
(21) Application number: 95112614.3
(22) Date of filing: 10.08.1995
(51) Int. Cl.: H03F 3/30

(54) **Operational amplifier**

(30) Priority: 12.08.1994 JP 190451/94
(71) Applicant: NEC CORPORATION, Tokyo (JP)
(72) Inventor: Kato, Fumihiko, c/o NEC Corp., Tokyo (JP)
(74) Representative: Baronetzky, Klaus, Dipl.-Ing.

(57) **Abstract**

An operational amplifier includes an input stage supplied with an input signal and an output signal which responds to an intermediate signal from the input stage and produces an output signal at an output terminal. The output stage includes a first field effect or bipolar transistor coupled between a first power terminal and the output terminal and driven by the intermediate signal, a phase-inverting circuit responding to the intermediate signal and producing a phase-inverted signal, and a second field effect or bipolar transistor coupled between a second power terminal and the output terminal and driven by the phase-inverted signal, the first transistor having a channel type or a conductivity type equal to that of the second transistor.

## Description

### BACKGROUND OF THE INVENTION

### Field of the Invention

The present invention relates an operational amplifier and, more particularly, to an improvement in an output stage of an operational amplifier.

### Description of the Prior Art

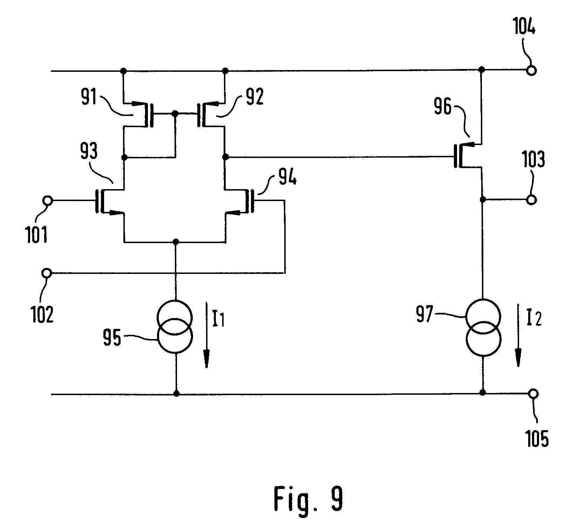

A typical operational amplifier is constructed as shown in Fig. 9. More specifically, this operational amplifier includes N-channel FETs 93 and 94 whose sources are connected in common to a current source 95 and whose gates are connected respectively to signal input terminals 101 and 102. The constant current source 95 has the other end connected to a first power supply terminal 105. An active load circuit is provided for the FETs 93 and 94, which circuit is a so-called current mirror circuit composed of P-channel FETs 91 and 92 connected as shown. These transistors and the current source 95 constitutes an input stage, an output of which is in turn supplied to an output stage. This output higher power supply terminal 104 and whose drain stage includes a P-channel FET 96 having a source connected to a second power supply terminal 104, a gate connected to the drain of the FET 92 to receive the output of the input signal and a drain connected to an signal output terminal 103, and a constant current source 97 connected between the lower power supply terminal 105 and the signal output terminal 103.

In operation, an input signal between the terminals 101 and 102 is amplified by the input stage and supplied to the gate of the FET 96, so that the potential at the signal output terminal 103 rises or drops. For example, the gate voltage of the P-channel FET 96 is lowered when the signal input terminal 102 has a higher potential than the signal input terminal 101. A current fed from the higher power supply terminal 104 through the P-channel FET 96 is thereby increased to raise the potential of the signal output terminal 103. Conversely, the gate voltage of the P-channel FET 96 is increased when the potential of the signal input terminal 102 is lower than that of the signal input terminal 101, so that the current flowing through the P-channel FET 96 is lowered. The potential of the signal output terminal 103 is thereby lowered by the constant current source 97.

As is apparent from the foregoing description, the signal output terminal 103 is lowered in potential by the current source 97. The current of the current source 97 is constant, not varied dynamical, unlike a transistor. For this reason, the falling time of the output voltage is greatly prolonged compared with the rising time.

### SUMMARY OF THE INVENTION

It is an object of the present invention to provide an operational amplifier shortening the rising and the falling time with a lower circuit device count.

An operational amplifier according to the present invention is characterized in that an output stage thereof includes a first transistor driving an output terminal in response to an intermediate signal that is produced by an input stage in response to an input signal, and a second transistor driving the output terminal in response to a phase-inverted signal of the intermediate signal.

### BRIEF DESCRIPTION OF THE DRAWINGS

The above and other objects, features and advantages of the present invention will become more apparent from the following description taken in conjunction with the accompanying drawings, wherein:
Fig. 1 is a circuit diagram illustrative of a first embodiment of the present invention;
Fig. 2 is a circuit diagram illustrative of a second embodiment of the present invention;
Fig. 3 is a circuit diagram illustrative of a third embodiment of the present invention;
Fig. 4 is a circuit diagram illustrative of a fourth embodiment of the present invention;
Fig. 5 is a circuit diagram illustrative of a fifth embodiment of the present invention;
Fig. 6 is a circuit diagram illustrative of a sixth embodiment of the present invention;
Fig. 7 is a circuit diagram illustrative of a seventh embodiment of the present invention;
Fig. 8 is a circuit diagram illustrative of an eighth embodiment of the present invention; and
Fig. 9 is a circuit diagram illustrative of a prior art.

### DETAILED DESCRIPTION OF THE PREFERRED EMBODIMENTS

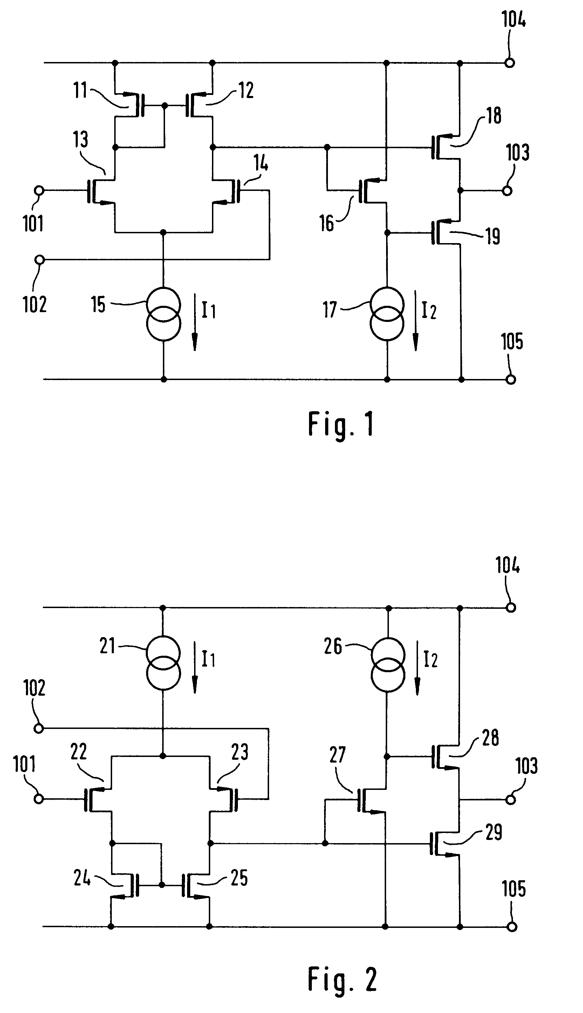

Referring now to Fig. 1, an operational amplifier according to a first embodiment of the present invention comprises an input stage and an output stage. The input stage includes N-channel MOS FETs 13 and 14 whose sources are connected in common to one end of a current source 15 and whose gates are connected respectively to signal input terminals 101 and 102 between which an input signal is supplied. The constant current source 15 has the other end connected to a first, lower power supply terminal 105. The N-channel FETs 13 and 14 thus constituted a differential circuit. As a load circuit, a P-channel MOS FETs 11 and 12 are provided to form a current whose gate and drain mirror circuit. Specifically, the gate and drain of the FET 11 are connected to the drain of the N-channel FET 13 and the source of the FET 11 is connected to a second, higher power supply terminal 104. The FET 12 has a gate connected to the drain of the N-channel FET 13, a source connected to the higher power supply terminal 104 and a drain connected to the drain of the N-channel FET 14. The output signal of the input stage is derived from the node of the drains of the FETs 12 and 14.

The output stage includes a P-channel MOS FET 16 having a source connected to the higher power supply terminal 104, a gate supplied with the signal from the input stage and a drain connected to one end of a constant current source 17 having the other end connected to the lower power supply terminal 105. The signal of the input stage is further supplied to the gate of a P-channel MOS FET 18 having a source connected to the higher power supply terminal 104 and a drain is connected to a signal output terminal 103. The output stage further includes a P-channel MOS FET 19 having a source connected to the signal output terminal 103, a gate connected to the drain of the P-channel FET 16 and a drain is connected to the lower power supply terminal 105.

In operation, when the voltage at the point of connection between the drain of the N-channel FET 14 and the drain of the P-channel FET 12, that is, the gate voltages of the P-channel FETs 16 and 18 are lowered by the signal input terminal 102 receiving a higher level of signal voltage than the signal input terminal 101, the gate voltage of the P-channel FET 19 is increased. Accordingly, the transistor 18 increases its driving capability, whereas the P-channel MOS FET 19 decreases its driving capability. Thus, the potential of the signal output terminal 103 raises promptly. Contrary, the gate voltages of the P-channel FETs 16 and 18 are increased by the signal input terminal 102 receiving a lower level of signal voltage than the signal input terminal 101, the gate voltage of the P-channel FET 19 is lowered. Accordingly, the FET 18 decreases its driving capability, whereas the FET 19 increases its driving capability, thereby promptly dropping the potential of the signal output terminal 103.

As described above, according to the present embodiment, when the output voltage rises, since a current flows from the higher power supply terminal 104 to the signal output terminal 103 via the P-channel FET 18 ready to pass a large current, the output voltage of the signal output terminal 103 is increased fast, while, when the output voltage falls, since a current flows from the signal output terminal 103 to the lower power supply terminal 105 via the P-channel FET 19 ready to pass a large current, the output voltage of the signal output terminal 103 falls promptly. In this way, both the rise time and the fall time of the output voltage of the signal output terminal 103 are notably shortened, and the response speed of the operational amplifier is further increased.

Fig. 2 is a circuit diagram illustrative of a second embodiment of the present invention. As shown in Fig. 2, this embodiment is constructed with P-channel FETs 22 and 23 whose sources are connected to a common terminal and whose gates are connected to respective signal input terminals 101 and 102; a constant current source 21 whose one end is connected to a higher power supply terminal 104 and whose other end is connected to the sources of the P-channel FETs 22 and 23; an N-channel FET 24 whose gate and drain are connected to the drain of the P-channel FET 22 and whose source is connected to a lower power supply terminal 105; an N-channel FET 25 whose gate is connected to the gate of the N-channel FET 24, whose source is connected to the lower power supply terminal 105 and whose drain is connected to the drain of the P-channel FET 23; an N-channel FET 27 whose source is connected to the lower power supply terminal 105 and whose gate is connected to the drain of the P-channel FET 23 and to the drain of the N-channel FET 25; a constant current source 26 whose one end is connected to the higher power supply terminal 104 and whose other end is connected to the drain of the N-channel FET 27; an N-channel FET 28 whose drain is connected to the higher power supply terminal 104, whose gate is connected to the drain of the N-channel FET 27 and whose source is connected to the signal output terminal 103; and an N-channel FET 29 whose drain is connected to the source of the N-channel FET 28 and to the signal output terminal 103, whose gate is connected to the gate of the N-channel FET 27 and whose source is connected to the lower power supply terminal 105.

In Fig. 2, with a differential amplifier comprising the P-channel FETs 22 and 23, the N-channel FETs 24 and 25 and the constant current source 21, the levels of output voltage to the gates of the N-channel FETs 27 and 29 change depending on the signal voltages inputted to the signal input terminals 101 and 102, and the gate voltage for the N-channel FET 28 changes accordingly. Under these conditions, in cases where the signal input terminal 102 receives a higher level of signal voltage than the signal input terminal 101, the voltage at the point of connection between the drain of the N-channel FET 25 and the drain of the P-channel FET 23, that is, the gate voltages of the N-channel FETs 27 and 29 are increased, and the gate voltage of the N-channel FET 28 which is connected to the drain of the P-channel FET 27 and to the other end of the constant current source 26 is lowered. Now, with regard to the operating status of the N-channel FETs 28 and 29, the N-channel FET 28 is not in a state which allows passage of a large current, whereas the N-channel FET 29 is ready to pass a large current, and as a result a current from the higher power supply terminal 104 is interrupted, and instead, a current flows to the lower power supply terminal 105 to promptly lower the voltage of the signal output terminal 103. Contrary, in cases where the signal input terminal 102 receives a lower level of signal voltage than the signal input terminal 101, the gate voltages of the N-channel FETs 27 and 29 are lowered, and thus the gate voltage of the N-channel FET 28 is increased. Now, with regard to the operating status of the N-channel FETs 28 and 29, the N-channel FET 28 is ready to pass a large current, whereas the N-channel FET 29 is not in a state which allows passage of a large current, and eventually a current from the higher power supply terminal 104 is interrupted, and instead, a current flows to the lower power supply terminal 105 to promptly drop the potential of the signal output terminal 103.

As described above, according to the present embodiment, when the output voltage rises, since a current flows from the higher power supply terminal 104 to the signal output terminal 103 via the N-chennel FET 28 ready to pass a large current, the output voltage of the signal output terminal 103 is increased fast, while, when the output voltage falls, since a current flows from the signal output terminal 103 to the lower power supply terminal 105 via the N-channel FET 29 which is ready to pass a large current, the output voltage of the signal output terminal 103 falls promptly. In this way, in the same manner as in the first embodiment, both the rise time and the fall time of the output voltage of the signal output terminal 103 are notably shortened, and the response speed of the operational amplifier is further increased.

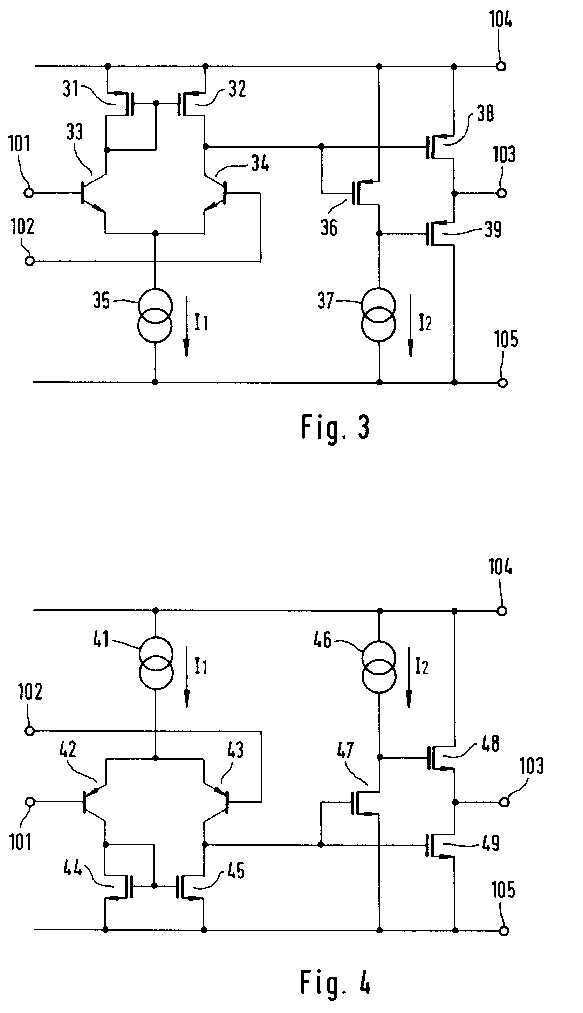

Fig. 3 is a circuit diagram illustrative of a third embodiment of the present invention. This embodiment and other embodiments which follow all are characterized in that the constituent semiconductor devices include a bipolar transistor such as NPN transistor and PNP transistor as a minor constituent, in addition to the major constituent FET.

As shown in Fig. 3, the present embodiment is constructed with NPN transistors 33 and 34 whose emitters are connected to a common terminal and whose bases are connected to respective signal input terminals 101 and 102; a constant current source 35 whose one end is connected to a lower power supply terminal 105 and whose other end is connected to the emitters of the NPN transistors 33 and 34; a P-channel FET 31 whose gate and drain are connected to the collector of the NPN transistor 33 and whose source is connected to a higher power supply terminal 104; a P-channel FET 32 whose gate is connected to the drains of the NPN transistor 33 and the P-channel FET 31, whose source is connected to the higher power supply terminal 104 and whose drain is connected to the collector of the NPN transistor 34; a P-channel FET 36 whose source is connected to the higher power supply terminal 104 and whose gate is connected to the drain of the P-channel FET 32 and to the collector of the NPN transistor 34; a constant current source 37 whose one end is connected to the lower power supply terminal 105 and whose other end is connected to the drain of the P-channel FET 36; a P-channel FET 38 whose source is connected to the higher power supply terminal 104, whose gate is connected to the gate of the P-channel FET 36 and whose drain is connected to the signal output terminal 103; and a P-channel FET 39 whose source is connected to the drain of the P-channel FET 38 and to the signal output terminal 103, whose gate is connected to the drain of the P-channel FET 36 and whose drain is connected to the lower power supply terminal 105.

As is apparent from comparison of Fig. 3 with Fig. 1 which illustrates the first embodiment, the present embodiment is a modification of the first embodiment described above which is constructed by replacing the N-channel FETs 13 and 14 by the NPN transistors 33 and 34, respectively.

In Fig. 3, with a differential amplifier comprising the NPN transistor FETs 33 and 34, the P-channel FETs 31 and 32 and the constant current source 35, the gate voltages of the P-channel FETs 36 and 38 are lowered in cases where the signal input terminal 102 receives a higher level of signal voltage than the signal input terminal 101, and the gate voltage of the P-channel FET 39 which is connected to the drain of the P-channel FET 36 and to the other end of the constant current source 37 is increased. Now, the P-channel FET 38 is ready to allow passage of a large current, whereas the P-channel FET 39 is not in a state which allows passage of a large current, and as a result a current flows from the higher power supply terminal 104 to the signal output terminal 103 of the operational amplifier, and thus the potential of the signal output terminal 103 raises promptly. Contrary, in cases where the signal input terminal 102 receives a lower level of signal voltage than the signal input terminal 101, the gate voltages of the P-channel FETs 36 and 38 are increased, for which the gate voltage of the P-channel FET 39 is lowered. Now, the P-channel FET 38 is not in a state which allows passage of a large current, whereas the P-channel FET 39 is ready to pass a large current, and eventually a current from the higher power supply terminal 104 is interrupted, and instead, a current flows to the lower power supply terminal 105 to promptly drop the potential of the signal output terminal 103.

The present embodiment is similar to the first embodiment in that both the rise time and the fall time of the output voltage of the signal output terminal 103 are notably shortened, and the response speed of the operational amplifier is further increased. However, although the present embodiment basically operates as an operational amplifier in the same manner as the first embodiment since the FET and the bipolar transistor generally has little difference in the function as operational amplifier, the present embodiment is a higher-precision operational amplifier than the first embodiment. This is because the bipolar transistor has a greater mutual conductance than the FET and thus allows acquisition of a higher gain.

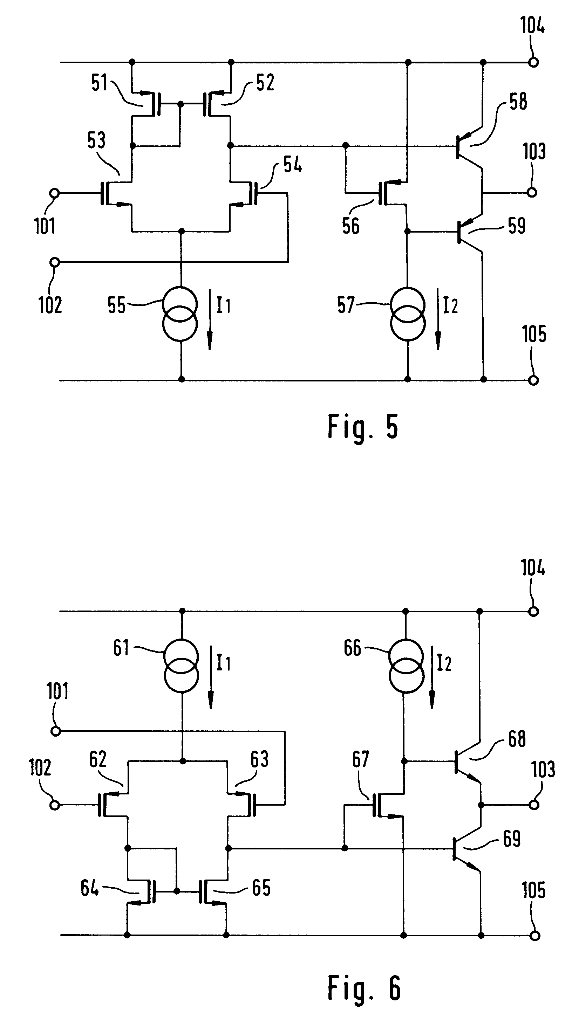

Fig. 4 is a circuit diagram illustrative of a fourth embodiment of the present invention. As shown in Fig. 4, the present embodiment is constructed with PNP transistors 42 and 43 whose emitters are connected to a common terminal and whose bases are connected to respective signal input terminals 101 and 102, a constant current source 41 whose one end is connected to a higher power supply terminal 104 and whose other end is connected to the emitters of the PNP transistors 42 and 43; an N-channel FET 44 whose gate and drain are connected to the collector of the PNP transistor 42 and whose source is connected to a lower power supply terminal 105; an N-channel FET 45 whose gate is connected to the gate and the drain of the N-channel FET 44, whose source is connected to the lower power supply terminal 105 and whose drain is connected to the collector of the PNP transistor 43; an N-channel FET 47 whose source is connected to the lower power supply terminal 105 and whose gate is connected to the collector of the PNP transistor 43 and to the drain of the N-channel FET 45; a constant current source 46 whose one end is connected to the higher power supply terminal 104 and whose other end is connected to the drain of the N-channel FET 47; an N-channel FET 48 whose drain is connected to the higher power supply terminal 104, whose gate is connected to the drain of the N-channel FET 47 and whose source is connected to the signal output terminal 103; and an N-channel FET 49 whose drain is connected to the source of the N-channel FET 48 and to the signal output terminal 103, whose gate is connected to the gate of the N-channel FET 47 and whose source is connected to the lower power supply terminal 105.

As is apparent from comparison of Fig. 4 with Fig. 2 which illustrates the second embodiment, the present embodiment is a modification of the second embodiment described above which is constructed by replacing the P-channel FETs 22 and 23 by the PNP transistors 42 and 43, respectively.

In Fig. 4, with a differential amplifier comprising the PNP transistor 42 and 43, the N-channel FETs 44 and 45 and the constant current source 41, in cases where the signal input terminal 102 receives a higher level of signal voltage than the signal input terminal 101, the gate voltages of the N-channel FETs 47 and 49 are increased, and the gate voltage of the N-channel FET 48 is lowered. In this way, now the N-channel FET 48 is not in a state which allows passage of a large current, and the N-channel FET 49 is ready to pass a large current, and aa a result a current from the higher power supply terminal 104 is interrupted, and instead, a current flows to the lower power supply terminal 105 to promptly drop the potential of the signal output terminal 103. Contrary, in cases where the signal input terminal 102 receives a lower level of signal voltage than the signal input terminal 101, the gate voltages of the N-channel FETs 47 and 49 are lowered, for which the gate voltage of the N-channel FET 48 is increased. Now, the N-channel FET 48 is ready to pass a large current, whereas the N-channel FET 49 is not in a state which allows passage of a large current, and eventually a current from the higher power supply terminal 104 is interrupted, and instead, a current flows to the lower power supply terminal 105 to promptly drop the potential of the signal output terminal 103.

The present embodiment is similar to the second embodiment in that both the rise time and the fall time of the output voltage of the signal output terminal 103 are notably shortened, that the response speed of the operational amplifier is further increased and that the fundamental operations as operational amplifier are identical. Nevertheless, the present embodiment is a higher-precision operational amplifier than the first embodiment since the bipolar transistor has a greater mutual conductance than the FET and thus allows acquisition of a higher gain.

Fig. 5 is a circuit diagram illustrative of a fifth embodiment of the present invention. As shown in Fig. 5, this embodiment is constructed with N-channel FETs 53 and 54 whose sources are connected to a common terminal and whose gates are connected to respective signal input terminals 101 and 102; a constant current source 55 whose one end is connected to a lower power supply terminal 105 and whose other end is connected to the sources of the N-channel FETs 53 and 54; a P-channel FET 51 whose gate and drain are connected to the drain of the N-channel FET 53 and whose source is connected to a higher power supply terminal 104; a P-channel FET 52 whose gate is connected to the drain of the N-channel FET 53, whose source is connected to the higher power supply terminal 104 and whose drain is connected to the drain of the N-channel FET 54; a P-channel FET 56 whose source is connected to the higher power supply terminal 104 and whose gate is connected to the drain of the P-channel FET 52 and to the drain of the N-channel FET 54; a constant current source 57 whose one end is connected to the lower power supply terminal 105 and whose other end is connected to the drain of the P-channel FET 56; an NPN transistor 58 whose emitter is connected to the higher power supply terminal 104, whose base is connected to the gate of the P-channel FET 56 and whose collector is connected to the signal output terminal 103; and a PNP transistor 59 whose emitter is connected to the collector of the PNP transistor 58 and to the signal output terminal 103, whose base is connected to the drain of the P-channel FET 56 and whose collector is connected to the lower power supply terminal 105.

As is apparent from comparison of Fig. 5 with Fig. 1 which illustrates the first embodiment, the present embodiment is a modification of the first embodiment described above which is constructed by replacing the P-channel FETs 18 and 19 by the PNP transistors 58 and 59, respectively.

In Fig. 5, with a differential amplifier comprising the N-channel FETs 53 and 54, the P-channel FETs 51 and 52 and the constant current source 55, in cases where the signal input terminal 102 receives a higher level of signal voltage than the signal input terminal 101, the base voltages of the P-channel FETs 56 and the PNP transistor 58 are lowered, for which the base voltage of the PNP transistor 59 is lowered. Now, the PNP transistor 58 is ready to pass a large current, whereas the PNP transistor 59 is not in a stage which allows passage of a large current, and as a result a current flows from the higher power supply terminal 104 to the signal output terminal 103 of the operational amplifier, and thus the potential of the signal output terminal 103 raises promptly. Contrary, in cases where the signal input terminal 102 receives a lower level of signal voltage than the signal input terminal 101, the gate voltage of the P-channel FET 56 and the base voltage of the PNP transistor 58 are increased, for which the base voltage of the PNP transistor 59 is lowered. Now, the PNP transistor 58 is not in a state which allows passage of a large current, whereas the PNP transistor 59 is ready to pass a large current, and eventually a current from the higher power supply terminal 104 is interrupted, and instead, a current flows to the lower power supply terminal 105 to promptly drop the potential of the signal output terminal 103.

The present embodiment is similar to the first embodiment in that both the rise time and the fall time of the output voltage of the signal output terminal 103 are notably shortened, that the response speed of the operational amplifier is further increased and that the fundamental operations as operational amplifier are identical. Nevertheless, the present embodiment is a higher-precision operational amplifier than the first embodiment since the bipolar transistor has a greater mutual conductance than the FET and thus allows acquisition of a higher gain.

Fig. 6 is a circuit diagram illustrative of a sixth embodiment of the present invention. As shown in Fig. 6, this embodiment is constructed with P-channel FETs 62 and 63 whose sources are connected to a common terminal and whose gates are connected to respective signal input terminals 101 and 102; a constant current source 61 whose one end is connected to a higher power supply terminal 104 and whose other end is connected to the sources of the P-channel FETs 62 and 63; an N-channel FET 64 whose gate and drain are connected to the drain of the P-channel FET 62 and whose source is connected to a lower power supply terminal 105; an N-channel FET 65 whose gate is connected to the gate of the N-channel FET 64, whose source is connected to the lower power supply terminal 105 and whose drain is connected to the drain of the P-channel FET 63; an N-channel FET 67 whose source is connected to the lower power supply terminal 105 and whose gate is connected to the drain of the P-channel FET 63 and to the drain of the N-channel FET 65; a constant current source 66 whose one end is connected to the higher power supply terminal 104 and whose other end is connected to the drain of the N-channel FET 67; an NPN transistor 68 whose collector is connected to the higher power supply terminal 104, whose base is connected to the drain of the N-channel FET 67 and whose source is connected to the signal output terminal 103; and an NPN transistor 69 whose collector is connected to the emitter of the NPN transistor 68 and to the signal output terminal 103, whose base is connected to the gate of the N-channel FET 67 and whose source is connected to the lower power supply terminal 105.

As is apparent from comparison with Fig. 2, the present embodiment is a modification of the second embodiment shown in Fig. 2 which is constructed by replacing the N-channel FETs 28 and 29 by the NPN transistors 68 and 69, respectively.

In Fig. 6, with a differential amplifier comprising the P-channel FETs 62 and 63, the N-channel FETs 64 and 65 and the constant current source 61, in cases where the signal input terminal 102 receives a higher level of signal voltage than the signal input terminal 101, the gate voltage of the N-channel FET 67 and the base voltage of the NPN transistor 69 are increased, whereas the base voltage of the NPN transistor 68 is lowered. Now, the N-channel FET 68 is not in a state which allows passage of a large current, whereas the NPN transistor 69 is ready to pass a large current, and as a result a current from the higher power supply terminal 104 is interrupted, and instead, a current flows to the lower power supply terminal 105 to promptly lower the potential of the signal output terminal 103. Contrary, in cases where the signal input terminal 102 receives a lower level of signal voltage than the signal input terminal 101, the gate voltage of the N-channel FET 67 and the base voltage of the NPN transistor 69 are lowered, and thus the base voltage of the NPN transistor 68 is increased. Now, the NPN transistor 68 is ready to pass a large current, whereas the NPN transistor 69 is not in a state which allows passage of a large current, and eventually a current flows from the higher power supply terminal 104 to the signal output terminal 103 of the operational amplifier to promptly raise the potential of the signal output terminal 103. Also, according to the present embodiment, both the rise time and the fall time of the output voltage of the signal output terminal 103 are shortened, and the response speed of the operational amplifier is further increased.

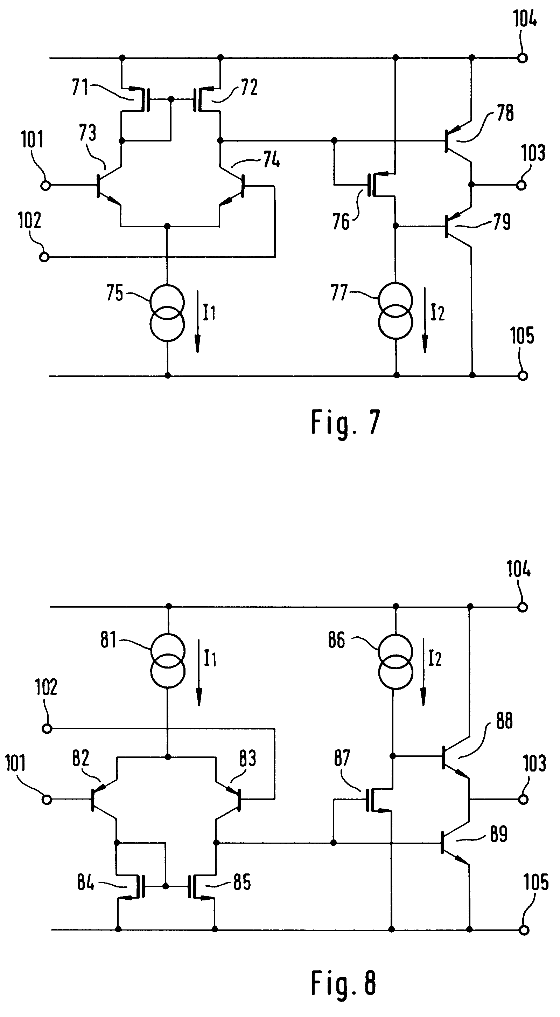

Fig. 7 is a circuit diagram illustrative of a seventh embodiment of the present invention. As shown in Fig. 7, the present embodiment is constructed with NPN transistors 73 and 74 whose emitters are connected to a common terminal and whose bases are connected to respective signal input terminals 101 and 102; a constant current source 75 whose one end is connected to a lower power supply terminal 105 and whose other end is connected to the emitters of the NPN transistors 73 and 74; a P-channel FET 71 whose gate and drain are connected to the collector of the NPN transistor 73 and whose source is connected to a higher power supply terminal 104; a P-channel FET 72 whose gate is connected to the collector of the NPN transistor 73, whose source is connected to the higher power supply terminal 104 and whose drain is connected to the collector of the NPN transistor 74; a P-channel FET 76 whose source is connected to the higher power supply terminal 104 and whose gate is connected to the drain of the P-channel FET 72 and to the collector of the NPN transistor 74; a constant current source 77 whose one end is connected to the lower power supply terminal 105 and whose other end is connected to the drain of the P-channel FET 76; a PNP transistor 78 whose emitter is connected to the higher power supply terminal 104, whose base is connected to the gate of the P-channel FET 76 and whose collector is connected to the signal output terminal 103; and a PNP transistor 79 whose emitter is connected to the collector of the PNP transistor 78 and to the signal output terminal 103, whose base is connected to the drain of the P-channel FET 76 and whose collector is connected to the lower power supply terminal 105.

As is apparent from comparison of Fig. 7 with Fig. 1 which illustrates the first embodiment, the present embodiment is a modification of the first embodiment described above which is constructed by replacing the N-channel FETs 13 and 14 by the NPN transistors 73 and 74, respectively, and the P-channel FETs 18 and 19 by the PNP transistors 78 and 79, respectively.

The operations of the present embodiment are the same as those of the first, third and fifth embodiments which have already been explained, and thus an explanation thereof will be omitted. In addition, although the present embodiment is similar to the first embodiment in that both the rise time and the fall time of the output voltage of the signal output terminal 103 are notably shortened, that the response speed of the operational amplifier is further increased and that the fundamental operations as operational amplifier are identical, the operational amplifier of the present embodiment is a higher-precision operational amplifier than the first embodiment since the bipolar transistor has a greater mutual conductance than the FET and thus allows acquisition of a higher gain.

Fig. 8 is a circuit diagram illustrative of a eighth embodiment of the present invention. As shown in Fig. 8, the present embodiment is constructed with PNP transistors 82 and 83 whose emitters are connected to a common terminal and whose bases are connected to respective signal input terminals 101 and 102; a constant current source 81 whose one end is connected to a higher power supply terminal 104 and whose other end is connected to the emitters of the PNP transistors 82 and 83; an N-channel FET 84 whose gate and drain are connected to the collector of the PNP transistor 82 and whose source is connected to a lower power supply terminal 105; an N-channel FET 85 whose gate is connected to the gate and the drain of the N-channel FET 84, whose source is connected to the lower power supply terminal 105 and whose drain is connected to the collector of the PNP transistor 83; an N-channel FET 47 whose source is connected to the lower power supply terminal 105 and whose gate is connected to the collector of the PNP transistor 83 and to the drain of the N-channel FET 85; a constant current source 86 whose one end is connected to the higher power supply terminal 104 and whose other end is connected to the drain of the N-channel FET 87; an NPN transistor 88 whose collector is connected to the higher power supply terminal 104, whose base is connected to the drain of the N-channel FET 87 and whose source is connected to the signal output terminal 103; and an NPN transistor 89 whose collector is connected to the emitter of the NPN transistor 88 and to the signal output terminal 103, whose base is connected to the gate of the N-channel FET 87 and whose emitter is connected to the lower power supply terminal 105.

As is apparent from comparison of Fig. 8 with Fig. 2 which illustrates the second embodiment, the present embodiment is a modification of the second embodiment described above which is constructed by replacing the P-channel FETs 22 and 23 by the PNP transistors 82 and 83, respectively, and the N-channel FETs 28 and 29 by the NPN transistors 88 and 89, respectively.

The operations of the present embodiment are the same as those of the second, fourth and sixth embodiments which have already been explained, and thus an explanation thereof will be omitted. In addition, although the present embodiment is similar to the second embodiment in that both the rise time and the fall time of the output voltage of the signal output terminal 103 are notably shortened, that the response speed of the operational amplifier is further increased and that the fundamental operations as operational amplifier are identical, the operational amplifier of the present embodiment is a higher-precision operational amplifier than the second embodiment since the bipolar transistor has a greater mutual conductance than the FET and thus allows acquisition of a higher gain.

Furthermore, as is evident from the foregoing description, the output voltages in the first, third, fifth and seventh embodiments and those in the second, fourth, sixth and eighth embodiments are opposite in polarity.

As explained above, the present invention produces the effect that the rise time and the fall time of operational amplifiers may be shortened by feeding a current through a signal output terminal when the output voltage rises or falls, via the FET or the bipolar transistor which is provided as a circuit component in an output stage instead of the constant current source.

## Claims

1. An amplifier comprising:
an input terminal supplied with an input signal;
an input stage coupled to said input terminal to amplifying said input signal and produce an amplified signal;
an output terminal; and
an output stage coupled to said input stage and said output terminal to produce an output signal at said output terminal in response to said amplified signal;
said output stage including a first transistor coupled between a first power terminal and said output terminal and having a control electrode supplied with said amplified signal, a second transistor coupled between a second power terminal and said output terminal and having a control electrode, a circuit node coupled to the control electrode of said second transistor, a third transistor coupled between said circuit node and said first power supply terminal and having a control electrode supplied with said amplified signal, and a current source coupled between said circuit node and said second power terminal.

2. The amplifier as claimed in claim 1, wherein each of said first, second and third transistors is a field effect transistor.

3. The amplifier as claimed in claim 1, wherein each of said first and second transistors is a field effect transistor and said third transistor is a bipolar transistor.

4. An amplifier comprising an input stage responding to an input signal and producing an intermediate signal and an output stage responding to said intermediate signal and producing an output signal at an output terminal, said output stage including a first transistor coupled between a first power terminal and said output terminal and driven by said intermediate signal, a phase-inverting circuit responding to said intermediate signal and producing a phase-inverted signal, and a second transistor coupled between a second power terminal and said output terminal and driven by said phase-inverted signal, said first transistor having a conductivity type equal to that of said second transistor.

5. The amplifier as claimed in claim 4, wherein each of said first and second transistors is a field effect transistor.

6. The amplifier as claimed in claim 4, wherein each of said first and second transistors is a bipolar transistor.
